# EUROPÄISCHE PATENTSCHRIFT

(11) **EP 2 412 214 B1**
(45) Veröffentlichungstag und Bekanntmachung des Hinweises auf die Patenterteilung: **31.10.2012**
(21) Anmeldenummer: 10705309.2
(22) Anmeldetag: 23.02.2010
(51) Int. Cl.: H05K 7/14, H05K 7/20

(54) **AUFNAHMERAHMEN FÜR MINDESTENS EINE LEITERKARTE**
RECEIVING FRAME FOR AT LEAST ONE CIRCUIT BOARD
CADRE DE LOGEMENT POUR AU MOINS UNE CARTE DE CIRCUIT IMPRIMÉ

(30) Priorität: 25.03.2009 DE 102009014803
(43) Veröffentlichungstag der Anmeldung: 01.02.2012
(73) Patentinhaber: Robert Bosch GmbH, 70469 Stuttgart (DE)
(72) Erfinder: SCHLUND, Gerald, 63755 Alzenau (DE); STEFANJUK, Oleg, 97846 Partenstein (DE)
(74) Vertreter: Thürer, Andreas
(86) Internationale Anmeldenummer: PCT/EP2010/001095
(87) Internationale Veröffentlichungsnummer: WO 2010/108578

(56) Entgegenhaltungen:
- DE-A1- 1 765 704
- DE-A1- 3 038 719
- US-A- 3 320 483

## Beschreibung

Die vorliegende Erfindung bezieht sich auf eine Kühlvorrichtung mit einem Aufnahmerahmen für mindestens eine Leiterkarte, auf ein elektrisches Regelgerät sowie auf ein Verfahren zum Herstellen eines elektrischen Regelgeräts.

Die Befestigung und Fixierung von Leiterkarten oder Platinen in einem elektrischen Geräts wird typischerweise mit dem gesamten Gehäuse des Gerätes verwirklicht. Diese Lösung ist jedoch unflexibel in Bezug auf Toleranzen der verschiedenen Teile. Zudem ist diese Lösung nicht geeignet, wenn die Leiterkarten in dem Gerät fixiert werden sollen, bevor das Gehäuse montiert wird.

DE 30 38 719 A1 beschreibt ein Chassis für die Aufnahme von elektronischen Baugruppen. Das Chassis weist mehrere U-förmige Einschubaufnahmen auf. An einer Stirnseite der aneinandergereihten Einschubaufnahmen ist eine Lüftereinrichtung angeordnet.

US 3 320 483 A beschreibt eine Aufnahmeanordnung für Einschubkarten.

DE 17 65 704 A1 beschreibt eine Anordnung zum Befestigen von mit Schaltelementen bestückten Steckkarten in Baugruppenträgern.

Es ist die Aufgabe der vorliegenden Erfindung eine verbesserte Kühlvorrichtung, ein verbessertes elektrisches Regelgerät sowie ein verbessertes Verfahren zum Herstellen eines elektrischen Regelgeräts zu schaffen.

Diese Aufgabe wird durch eine Kühlvorrichtung gemäß Anspruch 1, ein elektrisches Regelgerät gemäß Anspruch 11 sowie ein Verfahren zum Herstellen eines elektrischen Regelgeräts gemäß Anspruch 12 gelöst.

Der vorliegenden Erfindung liegt die Erkenntnis zu Grunde, dass sich eine Befestigung, Fixierung, Positionierung, Ausrichtung und Schirmableitung einer oder mehrerer Leiterkarten vorteilhafterweise mittels eines Aufnahmerahmens realisieren lässt. Der Aufnahmerahmen eignet sich insbesondere, um die Leiterkarten auf einem Kühlkörper anzuordnen bzw. auf dem Kühlkörper zu befestigen. Der Aufnahmerahmen kann in einem elektrischen Gerät und insbesondere einem Regelgerät eingesetzt werden.

Der Aufnahmerahmen ermöglicht eine Stabilisierung und Fixierung der Leiterkarten in alle Richtungen. Somit kann eine stabile Befestigung der Leiterkarten auch bei schwierigen Einsatzbedingungen gewährleistet werden, bei denen das Gerät beispielsweise starken Erschütterungen oder Vibrationen ausgesetzt ist. Die Befestigung und Fixierung aller Leiterkarten kann dabei durch ein Teil, nämlich den Aufnahmerahmen erfolgen.

Vorteilhafterweise muss der Aufnahmerahmen keinen komplexen geometrischen Aufbau aufweisen, stattdessen kann ein einfacher geometrischer Aufbau gewählt werden. Dadurch ist eine einfache und kostengünstige Fertigung möglich. Durch den einfachen geometrischen Aufbau des Aufnahmerahmens ist das Höhenmaß theoretisch genau definierbar. Dadurch ist es möglich, alle Toleranzen im Bezug auf die Befestigung und Fixierung aller Leiterkarten auszugleichen. Dabei können nicht nur die Toleranzen der Leiterkarten sondern die mitunter großen Toleranzen der verschiedenen Teile des Gerätes berücksichtigt werden.

Zudem ist eine einfache Montierbarkeit auch als eigenständige Einheit gegeben.

Die vorliegende Erfindung schafft eine Kühlvorrichtung mit einem kühlkörper und einem Aufnahmerahmen für mindestens eine Leiterkarte, mit folgenden Merkmalen: einem ersten Seitenelement mit einem ersten Anschlussstück und einem zweiten Seitenelement mit einem zweiten Anschlussstück, wobei die Anschlussstücke ausgebildet sind, um eine Verbindungsmöglichkeit zu einem Kühlkörper bereitzustellen; und einem Aufnahmeelement, das zwischen dem ersten und dem zweiten Seitenelement angeordnet ist und mindestens ein erstes Durchgangsloch aufweist, in das ein erstes Endstück mindestens einer Leiterkarte eingeführt werden kann, wobei der Aufnahmerahmen über die Anschlussstüche mit dem Kühlkörper verbunden ist und das Aufnahmeelemens parallel zu einer Oberfläche des Kühlkörpers ausgerichtet ist.

Der Aufnahmerahmen kann aus einem Blechteil ausgeformt sein, das beispielsweise U-förmig oder bügelförmig sein kann. Ein mittlerer Abschnitt des Blechteils kann dabei das Aufnahmeelement und beidseitig daran anschließende Abschnitte können die Seitenelemente ausbilden. Somit können das Aufnahmeelement, die Seitenelemente und die Endstücke aus einem Stück geformt sein, bzw. fest miteinander verbunden sein. Die Anschlussstücke können ausgebildet sein, um die Seitenelemente mit dem Kühlkörper mechanisch stabil zu verbinden. Dazu kann beispielsweise eine Schraub- oder Steckverbindung vorgesehen werden. Bei der Leiterkarte kann es sich um eine elektrische Leiterkarte oder Platine mit entsprechenden elektrischen Bauteilen, Schaltkreisen und Anschlusselementen handeln. Das erste Endstück der Leiterkarte kann einen Kontakt, einen Stecker, ein Bedienelement, ein Fixierelement und/oder ein Positionierelement aufweisen, die in das erste Durchgangsloch hineinreichen oder sich durch das erste Durchgangsloch hindurch erstrecken und aus einer der Leiterkarte gegenüberliegenden Seite des Aufnahmeelementes hervorstehen.

Ferner kann das Aufnahmeelement eine Fixiereinrichtung aufweisen, die ausgebildet ist, um die mindestens eine Leiterkarte an dem Aufnahmeelement zu fixieren. Auf diese Weise kann die Leiterplatte auch bei Vibrationen oder Erschütterungen in Position gehalten werden. Die Fixiereinrichtung kann beispielsweise Schaub- oder Klemmeinrichtungen und entsprechende Aussparungen oder Bohrungen aufweisen, mit deren Hilfe die Leiterkarte an dem Aufnahmeelement befestigt werden kann.

Die Seitenelemente und das Aufnahmeelement können rechtwinklig zueinander ausgerichtet sein. Dadurch können Längen der Seitenelemente und des Aufnahmeelements einfach an die aufzunehmenden Leiterkarten angepasst werden.

Somit ist das Aufnahmeelement parallel zu einer Oberfläche des Kühlkörpers ausgerichtet, wenn der Aufnahmerahmen mit dem Kühlkörper verbunden ist. Auf diese Weise kann der Aufnahmerahmen eine rechtwinklig zu der Oberfläche des Kühlkörpers angeordnete Leiterkarte aufnehmen.

Die Anschlussstücke können ausgebildet sein, um eine elektrisch leitfähige Verbindung zwischen dem Aufnahmerahmen und dem Kühlkörper bereitzustellen. Auf diese Weise kann über den Aufnahmerahmen eine Schirmableitung bzw. eine elektrische Abschirmung für die Leiterkarte bereitgestellt werden.

Beispielsweise kann die mindestens eine Leiterkarte als Steuerkarte eines elektrischen Regelgeräts ausgebildet sein. Somit kann der erfindungsgemäße Aufnahmerahmen im Zusammenhang mit Steuergeräten eingesetzt werden.

Bei dem Kühlkörper kann es sich um einen Kühlkörper für ein Leistungsteil eines elektrischen Geräts handeln. Der Kühlkörper kann aus Metall ausgeformt sein und eine Mehrzahl von Kühlrippen aufweisen. Der Aufnahmerahmen kann über die Anschlussstücke sowohl mechanisch als auch elektrisch leitend mit dem Kühlkörper verbunden sein.

Die Kühlvorrichtung kann eine Leiterplatte aufweisen, die mindestens eine Anschlusseinrichtung für ein zweites Endstück der mindestens einen Leiterkarte aufweisen kann, wobei die Leiterplatte parallel zu einer Oberfläche des Kühlkörpers und zumindest teilweise zwischen den Anschlussstücken angeordnet sein kann. Somit kann die Leiterkarte zusätzlich über die Leiterplatte fixiert werden und über diese kontaktiert werden. Durch die beidseitige Fixierung ist eine hohe Rüttelfestigkeit gegeben.

Beispielsweise kann die Leiterplatte als Leistungsleiterkarte ausgebildet sein. Die Leistungsleiterkarte kann Elektronik einer Leistungssteuerung aufweisen.

Ferner kann die Kühlvorrichtung mindestens ein Leistungsmodul aufweisen, das zwischen der Oberfläche des Kühlkörpers und der Leiterplatte angeordnet ist. Durch diese Anordnung wird eine Wärmeabfuhr von dem Leistungsmodul über den Kühlkörper gewährleistet.

Die Kühlvorrichtung kann ein Gehäuse aufweisen, das ausgebildet ist, um den Aufnahmerahmen und zumindest einen Abschnitt des Kühlkörpers aufzunehmen, wobei das Gehäuse mindestens ein zweites Durchgangsloch aufweisen kann, in das das erste Endstück der mindestens einen Leiterkarte eingeführt werden kann, wenn der Aufnahmerahmen und zumindest der Abschnitt des Kühlkörpers in dem Gehäuse angeordnet sind. Das zweite Durchgangsloch ermöglicht eine Kontaktierung der Leiterkarte von außerhalb des Gehäuses. Aufgrund des Aufnahmerahmens ist keine weitere Fixierung der Leiterkarte an dem Gehäuse erforderlich. Bei dem Gehäuse kann es sich um ein Blechgehäuse handeln. Je nach Ausführungsform kann der Kühlkörper vollständig von dem Gehäuse umschlossen werden oder teilweise aus dem Gehäuse hervorstehen. Somit kann beispielsweise der Teil des Kühlkörpers, auf dem der Aufnahmerahmen angeordnet ist, von dem Gehäuse umschlossen werden, Kühlrippen des Kühlkörpers können jedoch außerhalb des Gehäuses angeordnet sein.

Die Kühlvorrichtung kann die mindestens eine Leiterkarte aufweisen, wobei die mindestens eine Leiterkarte zwischen dem Kühlkörper und dem Aufnahmeelement angeordnet ist. Somit kann der Kühlkörper als Grundfläche dienen, auf der die Funktionseinheiten eines elektrischen Geräts platzsparen und stabil aufgebaut werden können.

Die vorliegende Erfindung schafft ferner ein elektrisches Regelgerät, mit einer erfindungsgemäßen Kühlvorrichtung. Somit kann der erfindungsgemäße Ansatz vorteilhaft zur Positionierung, Schirmung und Befestigung von Leiterkarten in einem Regelgerät eingesetzt werden.

Die vorliegende Erfindung schafft ferner ein Verfahren zum Herstellen eines elektrischen Regelgeräts, das die folgenden Schritte aufweist: Bereitstellen eines Kühlkörpers; Anordnen einer Leiterplatte parallel zu einer Oberfläche des Kühlkörpers, wobei die Leiterplatte mindestens eine Anschlusseinrichtung aufweist; Anordnen mindestens einer Leiterkarte auf der Leiterplatte, so dass ein zweites Endstück der mindestens einen Leiterkarte an der mindestens einen Anschlusseinrichtung angeschlossen wird; Anordnen eines Aufnahmerahmens mit einem ersten Seitenelement mit einem ersten Anschlussstück, einem zweiten Seitenelement mit einem zweiten Anschlussstück und einem Aufnahmeelement, das zwischen dem ersten und dem zweiten Seitenelement angeordnet ist und mindestens ein erstes Durchgangsloch aufweist, auf dem Kühlkörper, so dass die Anschlussstücke mit dem Kühlkörper verbunden werden und ein erstes Endstück der mindestens einen Leiterkarte in das mindestens eine Durchgangsloch eingeführt wird; und Anordnen eines Gehäuses, das mindestens ein zweites Durchgangsloch aufweist, um den Aufnahmerahmen und zumindest einen Abschnitt des Kühlkörpers, so dass das erste Endstück der mindestens einen Leiterkarte in das zweite Durchgangsloch eingerührt wird.

Das erfindungsgemäße Verfahren ermöglicht es, mehrere Leiterkarten fixiert, positioniert und mit Schirmableitung auf dem Kühlkörper zu befestigten. Bei der Befestigung und Fixierung der Leiterkarten können die großen Toleranzen der verschiedenen Teile berücksichtigt werden. Zudem wird eine Ausrichtung und stabile Befestigung der Leiterkarten auf dem Kühlkörper ermöglicht, bevor das elektrische Regelgerät mit dem Gehäuse versehen wird.

Die Erfindung wird nachstehend anhand der beigefügten Zeichnungen beispielhaft näher erläutert. Es zeigen:
- Fig. 1: eine Darstellung des erfindungsgemäßen Aufnahmerahmens von vorne;
- Fig. 2: eine erste Seitenansicht des erfindungsgemäßen Aufnahmerahmens;
- Fig. 3: eine zweite Seitenansicht des erfindungsgemäßen Aufnahmerahmens;
- Fig. 4: eine Darstellung des erfindungsgemäßen Aufnahmerahmens von oben;
- Fig. 5: eine weitere Darstellung des erfindungsgemäßen Aufnahmerahmens;
- Fig. 6: eine Darstellung eines Kühlkörpers mit einem Aufnahmerahmen, gemäß einem Ausführungsbeispiel der vorliegenden Erfindung;
- Fig. 7: eine weitere Darstellung eines Kühlkörpers mit einem Aufnahmerahmen, gemäß einem Ausführungsbeispiel der vorliegenden Erfindung;
- Fig. 8: eine weitere Darstellung eines Kühlkörpers mit einem Aufnahmerahmen, gemäß einem Ausführungsbeispiel der vorliegenden Erfindung;
- Fig. 9: eine weitere Darstellung eines Kühlkörpers mit einem Aufnahmerahmen, gemäß einem Ausführungsbeispiel der vorliegenden Erfindung; und
- Fig. 10: ein Ablaufdiagramm eines Verfahrens zum Herstellen eines elektrischen Regelgeräts, gemäß einem Ausführungsbeispiel der vorliegenden Erfindung.

Gleiche oder ähnliche Elemente können in den nachfolgenden Figuren durch gleiche oder ähnliche Bezugszeichen versehen sein. Ferner enthalten die Figuren der Zeichnungen, deren Beschreibung sowie die Ansprüche zahlreiche Merkmale in Kombination. Einem Fachmann ist dabei klar, dass diese Merkmale auch einzeln betrachtet werden oder sie zu weiteren, hier nicht explizit beschriebenen Kombinationen zusammengefasst werden können.

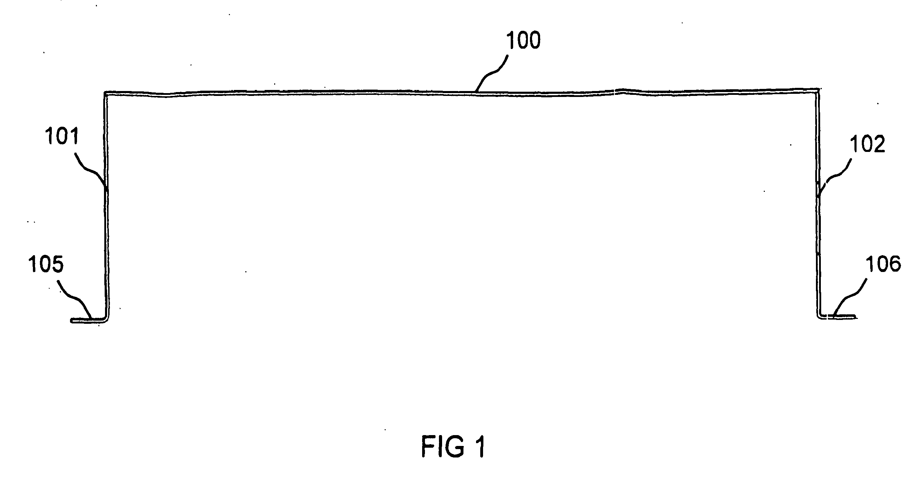

Fig. 1 zeigt einen Aufnahmerahmen für mindestens eine Leiterkarte, gemäß einem Ausführungsbeispiel der vorliegenden Erfindung. Der Aufnahmerahmen kann zusätzlich als Positionierrahmen und Schirmrahmen für die mindestens eine Leiterkarte dienen.

Der Aufnahmerahmen weist ein Aufnahmeelement 100 auf, das zwischen einem ersten Seitenelement 101 und einem zweiten Seitenelement 102 angeordnet ist. Das Aufnahmeelement 100 und die Seitenelemente 101, 102 können rechtwinklig zueinander angeordnet sein. Das Aufnahmeelement 100 kann an einem Ende der Seitenelemente 101, 102 angeordnet sein. An einem, dem Aufnahmeelement 100 gegenüberliegenden Ende der Seitenelemente 101, 102, weist das erste Seitenelement 101 ein erstes Anschlussstück 105 und das zweite Seitenelement 102 ein zweites Anschlussstück 106 auf. Die Anschlussstücke 105, 106 sind ausgebildet, um eine Verbindungsmöglichkeit zu einem Kühlkörper bereitzustellen, auf dem der Aufnahmerahmen angeordnet werden kann. Gemäß diesem Ausführungsbeispiel werden die Anschlussstücke 105, 106 jeweils von umgebogenen Endabschnitten der Seitenelemente 101, 102 gebildet. Die Anschlussstücke 105, 106 können rechtwinklig zu den Seitenelementen 101, 102 ausgerichtet sein und voneinander weg zeigen. Somit können die Anschlussstücke 105, 106 parallel zu dem Aufnahmeelement 100 angeordnet sein. Ferner können die Anschlussstücke 105, 106 parallel zu einer Oberfläche des Kühlkörpers ausgerichtet sein, auf dem der Aufnahmerahmen befestigt werden kann.

Gemäß diesem Ausführungsbeispiel werden das Aufnahmeelement 100, die Seitenelemente 101, 102 und die Anschlussstücke 105, 106 aus einem zusammenhängenden, entsprechend gebogenen Blechteil geformt. Das Blechteil kann aus Stahlblech bestehen.

Die Höhe der Seitenelemente 101, 102 kann an eine Länge der mindestens einen Leiterkarte angepasst sein. Die Länge des Aufnahmeelements 100 kann an eine Breite der mindestens einen Leiterkarte angepasst sein. Ist das Aufnahmeelement 100 ausgebildet, um mehrere nebeneinander angeordnete Leiterkarten aufzunehmen, so kann die Länge des Aufnahmeelements 100 entsprechend verlängert sein. Gemäß diesem Ausführungsbeispiel ist das Aufnahmeelement 100 ca. dreimal so lang wie die Seitenelemente 101, 102 hoch sind.

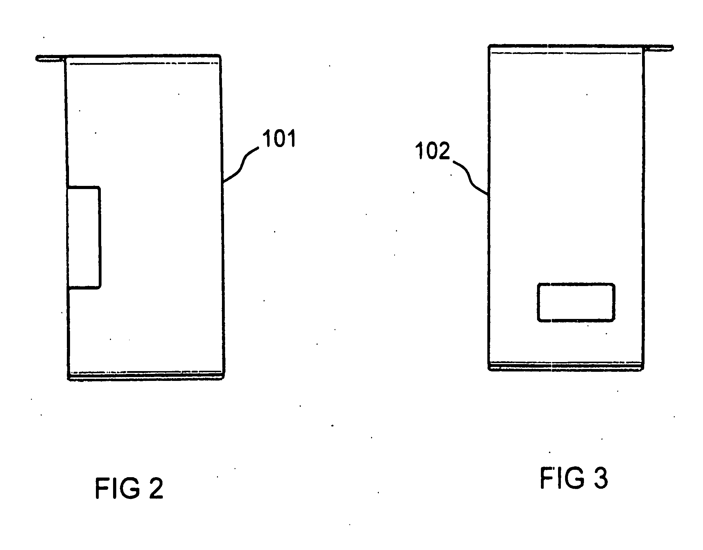

Fig. 2 zeigt eine Seitenansicht des in Fig. 1 gezeigten Aufnahmerahmens. Insbesondere ist das erste Seitenelement 101 gezeigt.

Fig. 3 zeigt eine weitere Seitenansicht des in Fig. 1 gezeigten Aufnahmerahmens. Insbesondere ist das zweite Seitenelement 102 gezeigt.

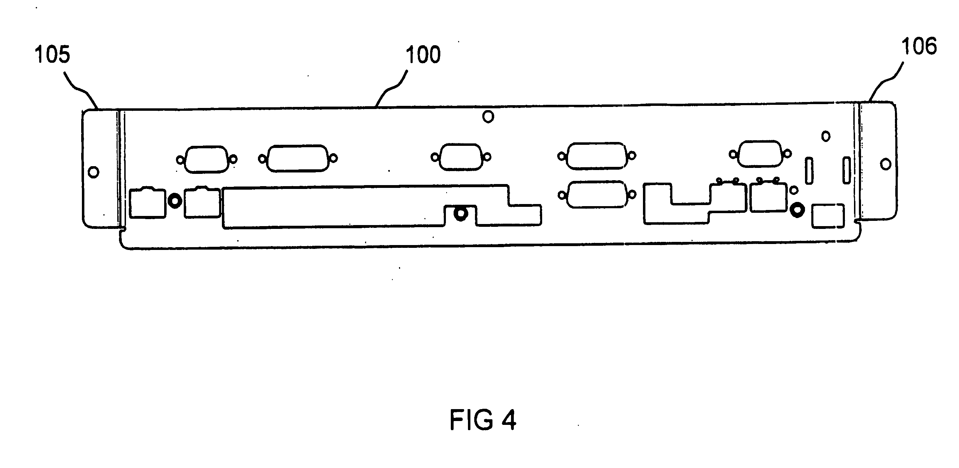

Fig. 4 zeigt eine Draufsicht des in Fig. 1 gezeigten Aufnahmerahmens. Insbesondere ist das Aufnahmeelement 100 und die Anschlussstücke 105, 106 gezeigt.

Die Anschlussstücke 105, 106 weisen jeweils ein Durchgangsloch auf. Die Durchgangslöcher können genutzt werden, um die Anschlussstücke 105, 106 mittels einer Schraubverbindung oder Steckverbindung auf dem Kühlkörper zu befestigen. Über eine solche Verbindung kann auch eine elektrische Verbindung zwischen den Anschlussstücken 105, 106 und dem Kühlkörper bereitgestellt werden, so dass der Aufnahmerahmen eine Schirmung aufgenommener Leiterkarten gewährleisten kann. Dabei können elektrische Störungen von dem Aufnahmerahmen auf den Kühlkörper abgeleitet werden.

Das Aufnahmeelement 100 weist eine Mehrzahl unterschiedlich ausgeformter Durchgangslöcher aus. Die Durchgangslöcher sind an Leiterplatten angepasst, die von dem Aufnahmerahmen aufgenommen werden können. Zumindest eines der Durchgangslöcher kann so ausgeformt sein, dass ein Endstück einer aufzunehmenden Leiterkarte durchgerührt werden kann. Beispielsweise kann ein Anschlussbereich der Leiterkarte durch das Durchgangsloch geführt werden, so dass dieser über der, der Leiterkarte gegenüberliegenden Oberfläche des Aufnahmeelements 100 hervorsteht. Bei dem Anschlussbereich der Leiterkarte kann es sich um einen Stecker, eine Steckerleiste, einen Leiterkartenrandstecker, eine Steckerbuchse oder ein ID-Sub Stecker handeln, die jeweils durch das Aufnahmeelement 100 positioniert und/oder fixiert werden können. Zumindest ein weiteres der Durchgangslöcher kann so ausgeformt sein, dass eine Fixierung oder Positionierung der aufzunehmenden Leiterkarte durchgeführt werden kann. Die Fixierung kann beispielsweise mittels einer Schraubverbindung erfolgen. Zumindest ein weiteres der Durchgangslöcher kann so ausgeformt sein, dass ein Bedienteil auf einer, der Leiterkarte gegenüberliegenden Seite des Aufnahmeelements 100 angeordnet und mit der Leiterkarte verbunden werden kann.

Die Breite des Aufnahmeelements 100 kann an eine Breite der aufzunehmenden Leiterkarte angepasst sein. Gemäß diesem Ausführungsbeispiel kann das Aufnahmeelement 100 zwei parallel zueinander angeordnete Leiterkarten aufnehmen. Somit ist eine Breite des Aufnahmeelements 100 an die doppelte Breite einer Leiterkarte angepasst. Gemäß diesem Ausführungsbeispiel ist das Aufnahmeelement 100 ungefähr sechsmal so lang wie breit. Alternativ kann das Aufnahmeelement 100 ausgebildet sein, um weitere Leiterkarten in weiteren Ebenen aufzunehmen.

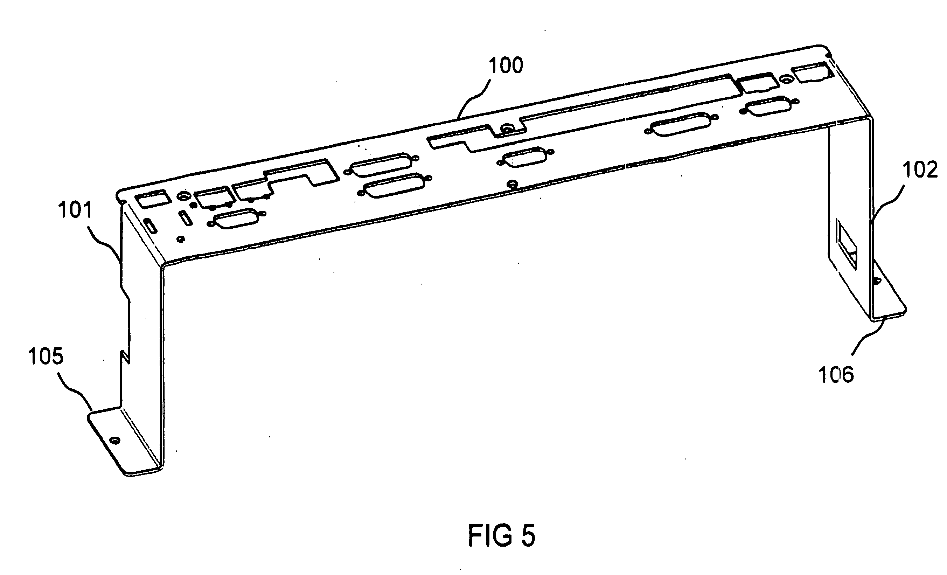

Fig. 5 zeigt eine weitere Darstellung des in Fig.1 gezeigten Aufnahmerahmens.

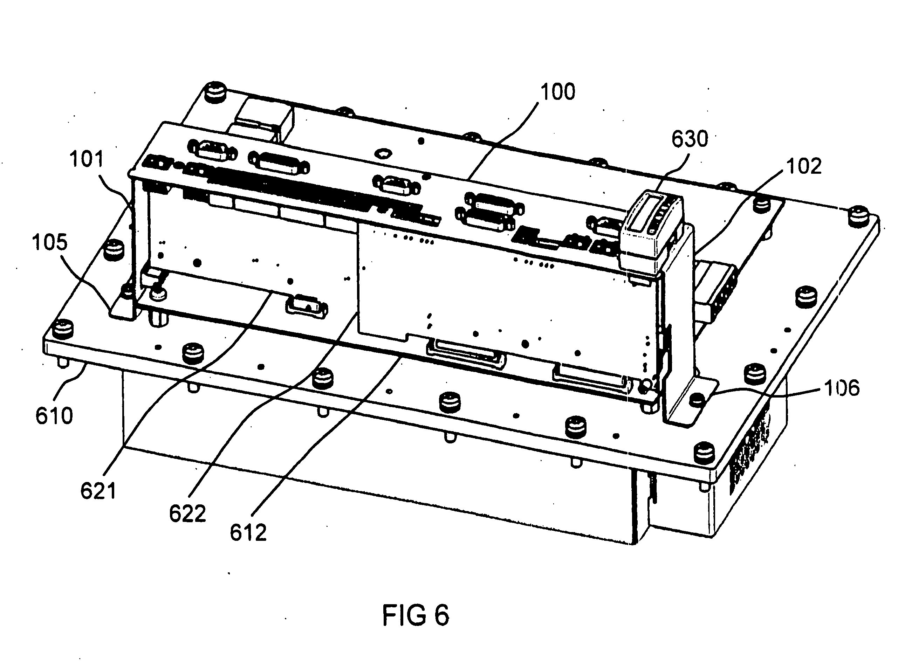

Fig. 6 zeigt eine Darstellung eines Kühlkörpers 610 gemäß einem Ausführungsbeispiel der vorliegenden Erfindung. Auf dem Kühlköper ist der in Fig. 1 gezeigte Aufnahmerahmen befestigt. Die Befestigung des Aufnahmerahmens kann dadurch erfolgen, dass die Anschlussstücke 105, 106 mit einer Oberfläche des Kühlkörpers 610 verschraubt sind. Ferner sind eine Leiterplatte 612 und zwei Leiterkarten 621, 622 gezeigt. Die Leiterplatte 612 kann parallel und beabstandet zu der Oberfläche des Kühlkörpers 610 angeordnet sein. Dazu kann die Leiterplatte 612 mittels Abstandshaltern mit dem Kühlkörper 610 verbunden sein. Zumindest ein Abschnitt der Leiterplatte 612 ist zwischen den Anschlussstücken 105, 106 angeordnet. Die Leiterkarten 621, 622 sind zwischen dem Aufnahmeelement 100 und der Leiterplatte 612 angeordnet und somit rechtwinklig zu der Oberfläche des Kühlkörpers 610 ausgerichtet:

In Fig. 6 sind Steckverbindungen der Leiterkarten 621, 622 gezeigt, die durch die Durchgangslöcher des Aufnahmeelements 100 geführt sind. Ferner sind Schraubverbindungen gezeigt, mittels denen die Leiterkarten 621, 622 gegenüber dem Aufnahmeelement 100 fixiert sind. Auch ist ein Bedienelement 630 gezeigt, das auf dem Aufnahmeelement 100 befestigt ist.

Die Leiterplatte 612 weist Steckverbindungen auf, in die die Leiterkarten 621, 622 eingesteckt werden können. Über die Steckverbindungen können die Leiterkarten 621, 622 kontaktiert und fixiert werden. Auf diese Weise können die Leiterkarten 621, 622 beidseitig, sowohl auf der Seite des Aufnahmeelements 100 als auch auf der Seite der Leiterplatte 612 befestigt werden.

Bei der Leiterplatte 612 kann es sich um eine Leistungsleiterkarte handeln, auf der Leistungssmodule angeordnet sein können. Bei den Leiterkarte 621, 622 kann es sich um stehende Steuerkarten eines elektrischen Regelgeräts mit entsprechenden elektrischen Bauteilen und Schaltkreisen handeln. Bei dem Kühlkörper 610 kann es sich um einen Metallkörper mit geeigneten Kühleinrichtungen und Kühlrippen handeln. Der Kühlkörper 610 kann geeignet sein, um eine von den Leiterkarten 621, 622 und insbesondere von der Leiterplatte 612 erzeugte Wärme abzuführen. Der Kühlkörper 610 kann eine massive Grundplatte aufweisen, auf der der Aufnahmerahmen stabil befestigt sein kann.

Die Anordnung aus Kühlkörper 610 und Aufnahmerahmen kann Teil eines elektrischen Geräts und insbesondere eines Steuergeräts oder eines Regel gerätes sein. Die Anordnung kann vollständig oder teilweise von einem Gehäuse umschlossen werden. Bei dem Gehäuse kann es sich um ein Gehäuse aus Metall handeln. Das Gehäuse kann in dem Bereich des Aufnahmerahmens Durchgangslöcher aufweisen, durch die die Steckverbindungen der Leiterkarten 621, 622 sowie das Bedienelement 630 geführt werden können. Dazu können Durchgangslöcher des Gehäuses an entsprechende Durchgangslöcher des Aufnahmeelements angepasst und gegenüber diesen ausgerichtet sein. Somit können die Leiterkarten 621, 622 von außerhalb des Gehäuses, also durch die Öffnungen des Gehäuses und des Aufnahmeelements 100 hindurch kontaktiert werden. Eine zusätzliche Befestigung der Leiterkarten 621, 622 gegenüber dem Gehäuse ist nicht erforderlich und gemäß diesem Ausführungsbeispiel nicht vorhanden.

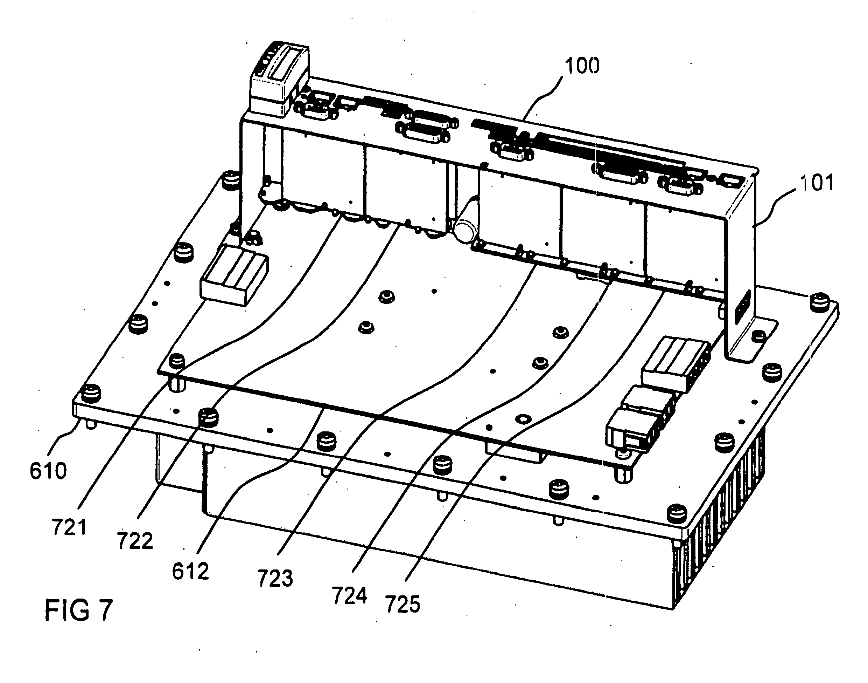

Fig. 7 zeigt eine weitere Ansicht des in Fig. 6 gezeigten Kühlkörpers 610, auf dem der Aufnahmerahmen befestigt ist. Fig. 7 zeigt weitere Leiterkarte 721, 722, 723, 724, 725, die zwischen dem Aufnahmeelement 100 und der Leiterplatte 612 angeordnet sind. Die Leiterkarten 721, 722, 723, 724, 725 sind nebeneinander stehend angeordnet.

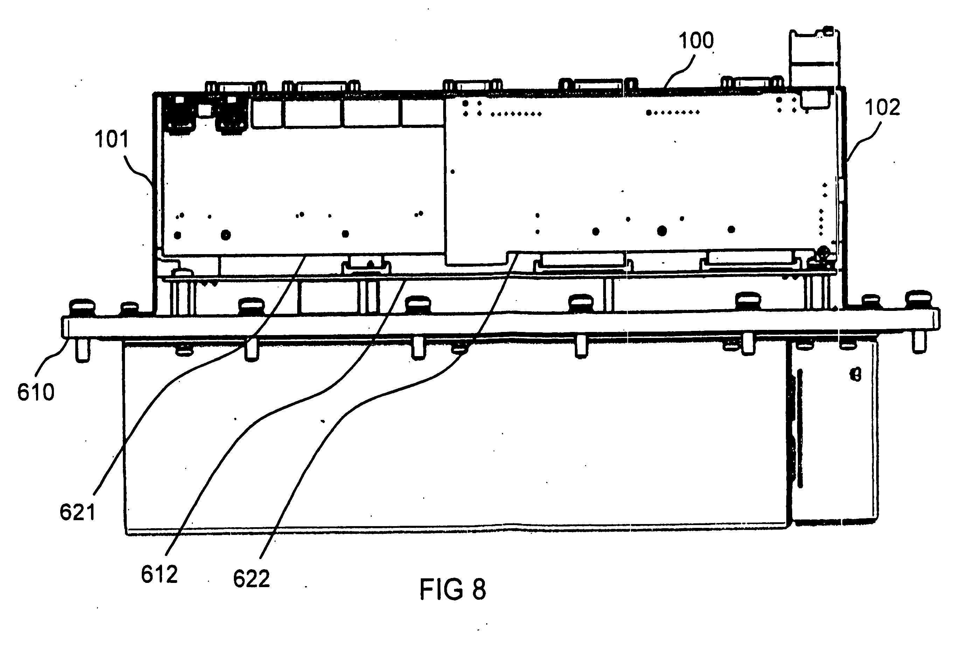

Fig. 8 zeigt eine weitere Ansicht des in Fig. 6 gezeigten Kühlkörpers 610, auf dem der Aufnahmerahmen befestigt ist.

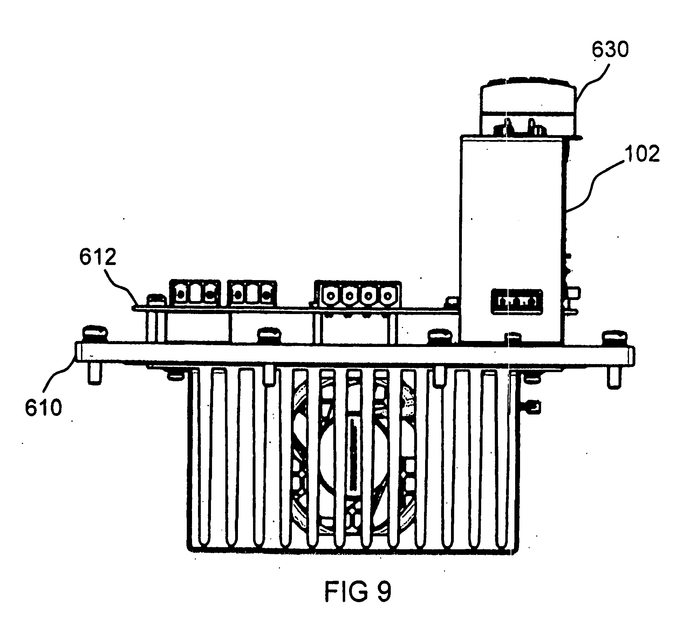

Fig. 9 zeigt eine weitere Ansicht des in Fig. 6 gezeigten Kühlkörpers 610, auf dem der Aufnahmerahmen befestigt ist. Der Kühlkörper 610 weist eine Grundplatte und, auf einer der Leiterplatte 612 gegenüberliegenden Seite, von der Grundplatte abstehende Kühlrippen auf. In Fig. 9 ist ferner ein Ventilator des Kühlkörpers 610 gezeigt, der im Bereich der Kühlrippen angeordnet ist.

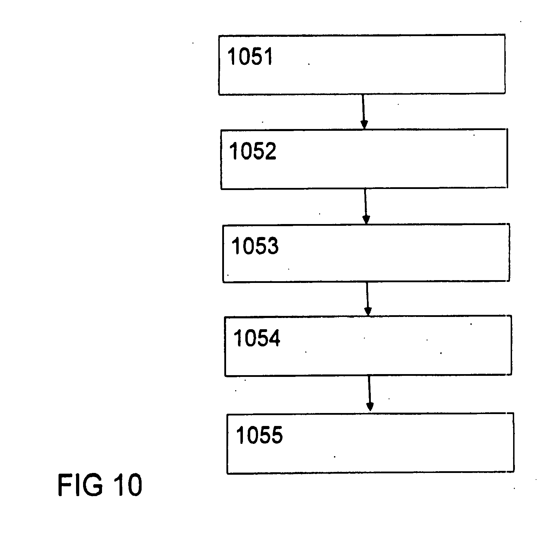

Fig. 10 zeigt ein Ablaufdiagramm eines Verfahrens zum Herstellen eines elektrischen Regelgeräts, gemäß einem Ausführungsbeispiel der vorliegenden Erfindung. Dabei kann zunächst ein Kühlkörper bereitgestellt 1051 werden. Anschließend kann eine Leiterplatte parallel zu einer Oberfläche des Kühlkörpers angeordnet 1052 werden. Auf der Leiterplatte kann mindestens eine Leiterkarte angeordnet 1053 werden. Dazu kann die mindestens eine Leiterkarte in ein Verbindungselement der Leiterplatte eingesteckt werden. Ein Aufnahmerahmen kann auf dem Kühlkörper angeordnet 1054 werden. Dabei kann die mindestens eine Leiterkarte durch den Aufnahmerahmen positioniert und fixiert werden. Anschließend kann ein Gehäuse bereitgestellt 1055 werden, das den Aufnahmerahmen und zumindest einen Abschnitt des Kühlkörpers umschließt.

Die gezeigten Ausführungsbeispiele sind nur beispielhaft gewählt und können miteinander kombiniert werden. Die beschriebenen Elemente können durch geeignete andere Elemente ersetzt werden. Auch können andere als die beschriebenen Materialien eingesetzt werden. Die beschriebenen Verfahrensschritte können in einer anderen als der beschriebenen Reihenfolge und wiederholt ausgeführt werden.

### Bezugszeichenliste

- 100: Aufnahmeelement
- 101, 102: Seitenelemente
- 105, 106: Anschlussstücke
- 610: Kühlkörper
- 612: Leiterplatte
- 621, 622: Leiterkarten
- 630: Bedienelement
- 721, 722, 723, 724, 725: Leiterkarten
- 1051, 1052, 1053, 1054, 1055: Verfahrensschritte

## Patentansprüche

1. Kühlvorrichtung mit einem Kühlkörper (610) und einem Aufnahmerahmen für mindestens eine Leiterkarte, wobei der Aufnahmerahmen ein erstes Seitenelement (101) mit einem ersten Anschlussstück (105), ein zweites Seitenelement (102) mit einem zweiten Anschlussstück (106) und ein Aufnahmeelement (100) aufweist, wobei die Anschlussstücke ausgebildet sind, um eine Verbindungsmöglichkeit zu dem Kühlkörper (610) bereitzustellen und das Aufnahmeelement (100) zwischen dem ersten und dem zweiten Seitenelement angeordnet ist und mindestens ein erstes Durchgangsloch aufweist, in das ein erstes Endstück der mindestens einen Leiterkarte (621, 622; 721, 722, 723, 724, 725) eingeführt werden kann, **dadurch gekennzeichnet, dass** der Aufnahmerahmen über die Anschlussstücke (105, 106) mit dem Kühlkörper verbunden ist und das Aufnahmeelement (100) parallel zu einer Oberfläche des Kühlkörpers (610) ausgerichtet ist.

2. Kühlvorrichtung gemäß Anspruch 1, bei dem das Aufnahmeelement (100) eine Fixiereinrichtung aufweist, die ausgebildet ist, um die mindestens eine Leiterkarte (621, 622; 721, 722, 723, 724, 725) an dem Aufnahmeelement zu fixieren.

3. Kühlvorrichtung gemäß einem der vorstehenden Ansprüche, bei dem die Seitenelemente (101, 102) und das Aufnahmeelement (100) rechtwinklig zueinander ausgerichtet sind.

4. Kühlvorrichtung gemäß einem der vorstehenden Ansprüche, bei dem die Anschlussstücke (105, 106) ausgebildet sind, um eine Schirmableitung zwischen dem Aufnahmerahmen und dem Kühlkörper (610) bereitzustellen.

5. Kühlvorrichtung gemäß einem der vorstehenden Ansprüche, mit einer Leiterplatte (612), die mindestens eine Anschlusseinrichtung für ein zweites Endstück der mindestens einen Leiterkarte (621, 622; 721, 722, 723, 724, 725) aufweist, wobei die Leiterplatte parallel zu einer Oberfläche des Kühlkörpers (610) und zumindest teilweise zwischen den Anschlussstücken (105, 106) angeordnet ist.

6. Kühlvorrichtung gemäß einem der vorstehenden Ansprüche, bei dem die Leiterplatte als Leistungsleiterkarte ausgebildet ist.

7. Kühlvorrichtung gemäß einem der vorstehenden Ansprüche, mit mindestens einem Leistungsmodul, das zwischen der Oberfläche des Kühlkörpers (610) und der Leiterplatte (612) angeordnet ist.

8. Kühlvorrichtung gemäß einem der vorstehenden Ansprüche, mit einem Gehäuse, das ausgebildet ist, um den Aufnahmerahmen und zumindest einen Abschnitt des Kühlkörpers aufzunehmen, wobei das Gehäuse mindestens ein zweites Durchgangsloch aufweist, in das das erste Endstück der mindestens einen Leiterkarte eingeführt werden kann, wenn der Kühlkörper und der Aufnahmerahmen in dem Gehäuse angeordnet sind.

9. Kühlvorrichtung gemäß einem der vorstehenden Ansprüche, mit der mindestens einen Leiterkarte (621, 622; 721, 722, 723, 724, 725), wobei die mindestens eine Leiterkarte zwischen dem Kühlkörper (610) und dem Aufnahmeelement (100) angeordnet ist.

10. Kühlvorrichtung gemäß Anspruch 9, bei dem die mindestens eine Leiterkarte (621, 622; 721, 722, 723, 724, 725) als Steuerkarte eines elektrischen Regelgeräts ausgebildet ist.

11. Elektrisches Regelgerät, mit einer Kühlvorrichtung gemäß einem der vorstehenden Ansprüche.

12. Verfahren zum Herstellen eines elektrischen Regelgeräts, das die folgenden Schritte aufweist:
Bereitstellen (1051) eines Kühlkörpers (610);
Anordnen (1052) einer Leiterplatte (612) parallel zu einer Oberfläche des Kühlkörpers, wobei die Leiterplatte mindestens eine Anschlusseinrichtung aufweist;
Anordnen (1053) mindestens einer Leiterkarte (621, 622; 721, 722, 723, 724, 725) auf der Leiterplatte, so dass ein zweites Endstück der mindestens einen Leiterkarte an der mindestens einen Anschlusseinrichtung angeschlossen wird;
Anordnen (1054) eines Aufnahmerahmens mit einem ersten Seitenelement (101) mit einem ersten Anschlussstück (105), einem zweiten Seitenelement (102) mit einem zweiten Anschlussstück (106) und einem Aufnahmeelement (100), das zwischen dem ersten und dem zweiten Seitenelement angeordnet ist und mindestens ein erstes Durchgangsloch aufweist, auf dem Kühlkörper, so dass die Anschlussstücke mit dem Kühlkörper verbunden werden und ein erstes Endstück der mindestens einen Leiterkarte in das mindestens eine Durchgangsloch eingeführt wird; und
Anordnen (1055) eines Gehäuses, das mindestens ein zweites Durchgangsloch aufweist, um den Aufnahmerahmen und zumindest einen Abschnitt des Kühlkörpers, so dass das erste Endstück der mindestens einen Leiterkarte in das zweite Durchgangsloch eingeführt wird.

## Claims

1. Cooling device having a heat sink (610) and a receiving frame for at least one printed circuit card, the receiving frame comprising a first side element (101) having a first connector (105), a second side element (106) having a second connector (106) and a receiving element (100), the connectors being designed for providing a possibility means of connection to the heat sink (610) and the receiving element (100) being arranged between the first and second side elements and comprising at least a first through-hole, into which a first end piece of the at least one printed circuit card (621, 622; 721, 722, 723, 724, 725) can be inserted, **characterized in that** the receiving frame is connected to the heat sink by way of the connectors (105, 106) and the receiving element (100) is aligned parallel to a surface of the heat sink (610).

2. Cooling device according to Claim 1, in which the receiving element (100) has a fixing device, which is designed for fixing the at least one printed circuit card (621, 622; 721, 722, 723, 724, 725) to the receiving element.

3. Cooling device according to one of the preceding claims, in which the side elements (101, 102) and the receiving element (100) are aligned at right angles to one another.

4. Cooling device according to one of the preceding claims, in which the connectors (105, 106) are designed for providing a shielding discharge between the receiving frame and the heat sink (610).

5. Cooling device according to one of the preceding claims, having a printed circuit board (612), which comprises at least one connecting device for a second end piece of the at least one printed circuit card (621, 622; 721, 722, 723, 724, 725), the printed circuit board being arranged parallel to a surface of the heat sink (610) and at least partially between the connectors (105, 106).

6. Cooling device according to one of the preceding claims, in which the printed circuit board is designed as a power printed circuit card.

7. Cooling device according to one of the preceding claims, with at least one power module, which is arranged between the surface of the heat sink (610) and the printed circuit board (612).

8. Cooling device according to one of the preceding claims, having a housing, which is designed for receiving the receiving frame and at least a portion of the heat sink, the housing comprising at least a second through-hole, into which the first end piece of the at least one printed circuit card can be inserted when the heat sink and the receiving frame are arranged in the housing.

9. Cooling device according to one of the preceding claims, having the at least one printed circuit card (621, 622; 721, 722, 723, 724, 725), the at least one printed circuit card being arranged between the heat sink (610) and the receiving element (100).

10. Cooling device according to Claim 9, in which the at least one printed circuit card (621, 622; 721, 722, 723, 724, 725) is designed as a control card of an electrical control unit.

11. Electrical control unit, having a cooling device according to one of the preceding claims.

12. Method for producing an electrical control unit comprising the following steps:
providing (1051) a heat sink (610);
arranging (1052) a printed circuit board (612) parallel to a surface of the heat sink, the printed circuit board having at least one connecting device;
arranging (1053) at least one printed circuit card (621, 622; 721, 722, 723, 724, 725) on the printed circuit board, so that a second end piece of the at least one printed circuit card is connected to the at least one connecting device;
arranging (1054) a receiving frame having a first side element (101) having a first connector (105), a second side element (102) having a second connector (106) and a receiving element (100), which is arranged between the first and second side elements and comprises at least a first through-hole, on the heat sink, so that the connectors are connected to the heat sink and a first end piece of the at least one printed circuit card is inserted into the at least one through-hole; and
arranging (1055) a housing, which comprises at least a second through-hole, around the receiving frame and at least a portion of the heat sink, so that the first end piece of the at least one printed circuit card is inserted into the second through-hole.

## Revendications

1. Dispositif de refroidissement équipé d'un corps de refroidissement (610) et d'un cadre de logement prévu pour recevoir au moins un circuit imprimé, le cadre de logement comportant un premier élément latéral (101) doté d'une première pièce de raccordement (105), un deuxième élément latéral (102) doté d'une deuxième pièce de raccordement (106) et un élément de logement (100), les pièces de raccordement étant réalisées pour offrir une possibilité de liaison avec le corps de refroidissement (610) et l'élément de logement (100) étant disposé entre le premier et le deuxième élément latéral et comportant au moins un premier trou traversant dans lequel une première pièce d'extrémité de l'au moins un circuit imprimé (621, 622 ; 721, 722, 723, 724, 725) peut être introduite, **caractérisé en ce que** le cadre de logement est relié au corps de refroidissement par le biais des pièces de raccordement (105, 106) et que l'élément de logement (100) est orienté parallèlement à une surface du corps de refroidissement (610).

2. Dispositif de refroidissement selon la revendication 1, dans lequel l'élément de logement (100) comporte un dispositif de fixation conçu pour fixer l'au moins un circuit imprimé (621, 622 ; 721, 722, 723, 724, 725) à l'élément de logement.

3. Dispositif de refroidissement selon l'une quelconque des revendications précédentes, dans lequel les éléments latéraux (101, 102) et l'élément de logement (100) sont orientés à angle droit les uns par rapport aux autres.

4. Dispositif de refroidissement selon l'une quelconque des revendications précédentes, dans lequel les pièces de raccordement (105, 106) sont réalisées pour mettre à disposition un déflecteur de protection entre le cadre de logement et le corps de refroidissement (610).

5. Dispositif de refroidissement selon l'une quelconque des revendications précédentes, avec une plaque conductrice (612) comportant au moins un dispositif de raccordement prévu pour une deuxième pièce d'extrémité de l'au moins un circuit imprimé (621, 622 ; 721, 722, 723, 724, 725), la plaque conductrice étant disposée parallèlement à une surface du corps de refroidissement (610) ainsi qu'au moins en partie entre les pièces de raccordement (105, 106).

6. Dispositif de refroidissement selon l'une quelconque des revendications précédentes, dans lequel la plaque conductrice prend la forme d'une carte conductrice de puissance.

7. Dispositif de refroidissement selon l'une quelconque des revendications précédentes, avec au moins un module de puissance disposé entre la surface du corps de refroidissement (610) et la plaque conductrice (612).

8. Dispositif de refroidissement selon l'une quelconque des revendications précédentes, avec un carter conçu pour loger le cadre de logement et au moins une section du corps de refroidissement, le carter comportant au moins un deuxième trou traversant dans lequel la première pièce d'extrémité de l'au moins un circuit imprimé peut être introduite lorsque le corps de refroidissement et le cadre de logement sont disposés dans le carter.

9. Dispositif de refroidissement selon l'une quelconque des revendications précédentes, comportant l'au moins un circuit imprimé (621, 622 ; 721, 722, 723, 724, 725), l'au moins un circuit imprimé étant disposé entre le corps de refroidissement (610) et l'élément de logement (100).

10. Dispositif de refroidissement selon la revendication 9, dans lequel l'au moins un circuit imprimé (621, 622 ; 721, 722, 723, 724, 725) prend la forme d'une carte de commande d'un appareil de régulation électrique.

11. Appareil de régulation électrique, équipé d'un dispositif de refroidissement selon l'une quelconque des revendications précédentes.

12. Procédé de fabrication d'un appareil de régulation électrique, suivant les étapes suivantes :
mise à disposition (1051) d'un corps de refroidissement (610) ;
agencement (1052) d'une plaque conductrice (612) parallèlement à une surface du corps de refroidissement, le circuit imprimé comportant au moins un dispositif de raccordement ;
agencement (1053) d'au moins un circuit imprimé (621, 622 ; 721, 722, 723, 724, 725) sur la plaque conductrice, de façon à raccorder une deuxième pièce d'extrémité de l'au moins un circuit imprimé sur l'au moins un dispositif de raccordement ;
agencement (1054) d'un cadre de logement équipé d'un premier élément latéral (101) doté d'une première pièce de raccordement (105), d'un deuxième élément latéral (102) doté d'une deuxième pièce de raccordement (106) et d'un élément de logement (100) disposé entre le premier et le deuxième élément latéral et comportant au moins un premier trou traversant, sur le corps de refroidissement, de sorte que les pièces de raccordement sont reliées au corps de refroidissement et qu'une première pièce d'extrémité de l'au moins un circuit imprimé est introduite dans l'au moins un trou traversant ; et
agencement (1055) d'un carter comportant au moins un deuxième trou traversant entourant le cadre de logement et au moins une section du corps de refroidissement, de sorte que la première pièce d'extrémité de l'au moins un circuit imprimé est introduite dans le deuxième trou traversant.
